Europäisches Patentamt

European Patent Office

Office européen des brevets

(11) Publication number: **0 143 441**
A2

# (12) EUROPEAN PATENT APPLICATION

(21) Application number: **84114138.5**

(22) Date of filing: **22.11.84**

(51) Int. Cl.⁴: **H 01 L 23/48**

(30) Priority: **26.11.83  JP 222575/83**

(43) Date of publication of application: **05.06.85**
**Bulletin 85/23**

(84) Designated Contracting States: **DE FR GB**

(71) Applicant: **Kabushiki Kaisha Toshiba, 72, Horikawa-cho Saiwai-ku, Kawasaki-shi Kanagawa-ken 210 (JP)**

(72) Inventor: **Ono, Tadaaki c/o Patent Division, Kabushiki Kaisha Toshiba 1-1 Shibaura 1-chome, Minato-ku Tokyo 105 (JP)**
Inventor: **Arakawa, Hideo c/o Patent Division, Kabushiki Kaisha Toshiba 1-1 Shibaura 1-chome, Minato-ku Tokyo 105 (JP)**

(74) Representative: **Henkel, Feiler, Hänzel & Partner, Möhlstrasse 37, D-8000 München 80 (DE)**

(54) **Lead frame and the method of manufacturing the same.**

(57) A lead frame includes a base plate (20A), a plurality of lead bars (20B-1 to 20B-3) extending from the base plate (20A) in parallel with one another, and a tie bar for interconnecting these lead bars (20B-1 to 20B-3), and each of the lead bars (20B-1 to 20B-3) is formed of an upper portion (20B-1U to 20B-3U), a lower portion (20B-1L to 20B-3L) and a coupling portion (20B-1C to 20B-3C) for coupling these upper and lower portions (20B-1U to 20B-3U, 20B-1L to 20B-3L). A distance among the upper portions (20B-1U to 20B-3U) is set to be different from a distance among the lower portions (20B-1L to 20B-3L) by the coupling portion (20B-1C to 20B-3C).

EP 0 143 441 A2

- 1 -

Lead frame and the method of manufacturing the same

The present invention relates to a lead frame for use in a semiconductor device of the resin sealing type.

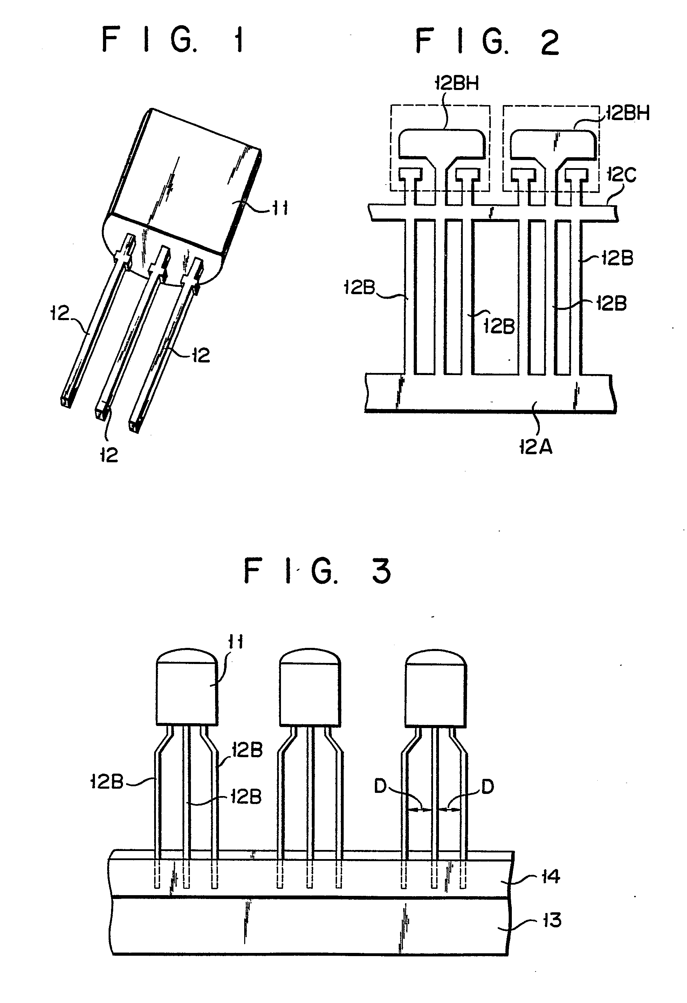

Conventionally, a resin-sealing-type semiconductor device as shown in, for example, Fig. 1 has been provided. This semiconductor device includes a resin mold 11 in which a semiconductor element or elements are enclosed and leads 12 respectively coupled to these semiconductor element electrodes. Fig. 2 shows a lead frame which is used in manufacturing this kind of resin-sealing-type semiconductor device. This lead frame has a base plate 12A, a plurality of lead bars 12B extending in parallel with one another from the base plate 12A, and a tie bar 12C extending in parallel with the base plate 12A and coupling those lead bars 12B. These lead bars 12B are divided into groups each having three lead bars. A head portion 12BH of the middle lead bar in each group is formed to be larger than the head portions of the lead bars on both sides in order to mount a semiconductor element or elements. The portions indicated by the broken lines in the diagram show the portions that are sealed with resin.

The lead frame having the base plate 12A, lead bars 12B and tie bar 12C shown in Fig. 2 is formed by, for example, selectively removing predetermined portions of a sheet of a thin metal plate by a punching method or etching method. A semiconductor element is mounted onto the head portion 12BH of each central lead bar of the lead frame formed in this way. After the bonding pads of this semiconductor element and the lead bars on both sides thereof were connected by lead wires, these semiconductor elements, head portions 12BH and lead wires are enclosed in a resin sealing member such as epoxy resin or the like. Next, the base plate 12A is separated from the lead bars 12B, and the tie bar 12C is removed, so that the resin sealing type semiconductor devices as shown in Fig. 1 are manufactured.

An automatic inserting apparatus is used to automatically insert the leads 12 of this semiconductor device into insertion holes in a printed circuit board (not shown). In this case, it is required to set the distances among these leads 12 in accordance with the distances among the insertion holes in the printed circuit board, so that the leads 12 of the semiconductor device can be automatically inserted into the insertion holes in the printed circuit board. In addition, for example, as shown in Fig. 3, it will be convenient if a number of semiconductor devices are aligned in a line at predetermined regular intervals and the leads 12 are stuck to a pasteboard 13 through an adhesive tape 14 so that those semiconductor devices can be sequentially supplied to the automatic inserting apparatus.

Ordinarily, on the side of the manufacturer, the leads 12 of the semiconductor device shown in Fig. 1 are subjected to bending, thereby allowing the leads on both sides to be separated from the central lead by a predetermined distance D. The semiconductor devices having the leads which were bent in this way are sequentially mounted on the pasteboard 13, then the lead bars 12B of these semiconductor devices are fixed onto the pasteboard 13 through the adhesive tape 14. The pasteboard 13 onto which the semiconductor devices were stuck in this way is wound around a reel or stacked in a zigzag like form; then, it is shipped in such a state.

0143441

In bending the leads 12 in accordance with the above-mentioned radial lead taping method, it is required to set the distances among the leads 12 with a high degree of accuracy, for instance, with an error less than ± 0.2 mm. In the case where the leads 12 of these semiconductor devices are inserted into the insertion holes in the printed circuit board on the user side, the automatic inserting apparatus which receives the semiconductor devices stuck to the pasteboard 13 takes up each semiconductor device from the pasteboard 13 by cutting the leads 12 of each semiconductor device to separate the semiconductor device from the pasteboard 13 or by peeling off the adhesive tape 14. The automatic inserting apparatus then grasps the leads 12 of the semiconductor device removed in this way and inserts these leads 12 into predetermined inserting holes in the printed circuit board. In this case, if the dimensional error of the distance D between the leads is large, there may be a case where the automatic inserting apparatus will have failed in grasping the leads 12 or failed in inserting the leads 12 into predetermined insertion holes. The percentage of success in which the leads can be successfully inserted into the insertion holes by the automatic inserting apparatus commonly used is about 99.5%. Therefore, when setting 0.1 million semiconductor devices, for instance, on the printed circuit board, this results in that the leads of about 500 semiconductor devices cannot be successfully inserted into the insertion holes. Unless the leads are inserted into the insertion holes, the operation of the automatic inserting apparatus will be temporarily stopped, and it will be necessary to remove the semiconductor device which could not be successfully set and thereafter to restart the automatic inserting apparatus. Due to this, the successful insertion ratio is largely influenced by an availability factor of the automatic inserting apparatus. In order to improve this availability factor, it is required to set the distance D between the leads with high accuracy. However, since this distance D is affected by the machining accuracy of the working mold upon bending the leads, by the elasticity of the leads, etc., it is difficult to set the distance D between the leads with a high degree of accuracy in compliance with the automatic inserting apparatus on the user side. For example, in the present situation, the distance D between the leads is set with an error of about ± 0.3 mm.

It is an object of the present invention to provide a lead frame in which the distance between the leads can be set with a high degree of accuracy.

This object is accomplished by a lead frame comprising: a base plate; a plurality of lead bars which extend from the base plate substantially in parallel with one another, and each of which has an upper portion, a lower portion, and a coupling portion for connecting these upper and lower portions, the distance between the upper portions being set to be different from the distance between the lower portions by the coupling portions; and a tie bar for connecting the coupling portions of these lead bars.

In this invention, the distance between the lead bars at the lower portions can be determined when the lead frame is formed, so that this distance can be set with high accuracy.

Another object of the invention is to provide a method of manufacturing a semiconductor in which the manufacturing steps are simplified by omitting the lead bending step.

This object is achieved by a method of manufacturing a semiconductor device comprising the steps of: preparing a lead frame including a plurality of distinguishable units which are joined with a base plate, each unit comprising substantially parallel lead bars which each have a lower portion extending from the base plate, a coupling portion and an upper portion in series, the distance between the upper portions being set to be different from the distance between the lower portions by the coupling portions, and a tie bar for connecting the coupling portions of these lead bars; mounting a semiconductor element onto the upper portion of one of the lead bars in each unit; electrically connecting an electrode pad of this semiconductor element and at least one of the lead bars in each unit by a lead wire; encapsulating the upper portion of the lead bar, onto which the semiconductor element was mounted, and the lead wire in a resin; and removing the base plate and tie bar to separate the unit having at least one lead bent by the presence of the coupling portion.

In this invention, when the lead frame is formed, the distance between the lower portions is determined to a predetermined value, so that there is no need to adjust this distance by bending the leads.

This invention can be more fully understood from the following detailed description when taken in conjunction with the accompanying drawings, in which:

Fig. 1 is a perspective view showing a semiconductor device of the resin sealed type which is formed using a conventional lead frame;

Fig. 2 is a plan view showing a conventional lead frame;

Fig. 3 illustrates a series of semiconductor devices of the resin sealing type which are formed using conventional lead frames and are stuck to a pasteboard due to a radial taping method;

Figs. 4A to 4C are diagrams showing manufacturing steps for explaining a method of manufacturing semiconductor devices of the resin sealing type using a lead frame according to one embodiment of the invention;

Fig. 5 is a diagram for explaining an arrangement of a lead frame unit of the lead frame according to one embodiment of the invention; and

Fig. 6 is a diagram showing an arrangement of a lead frame according to another embodiment of the invention.

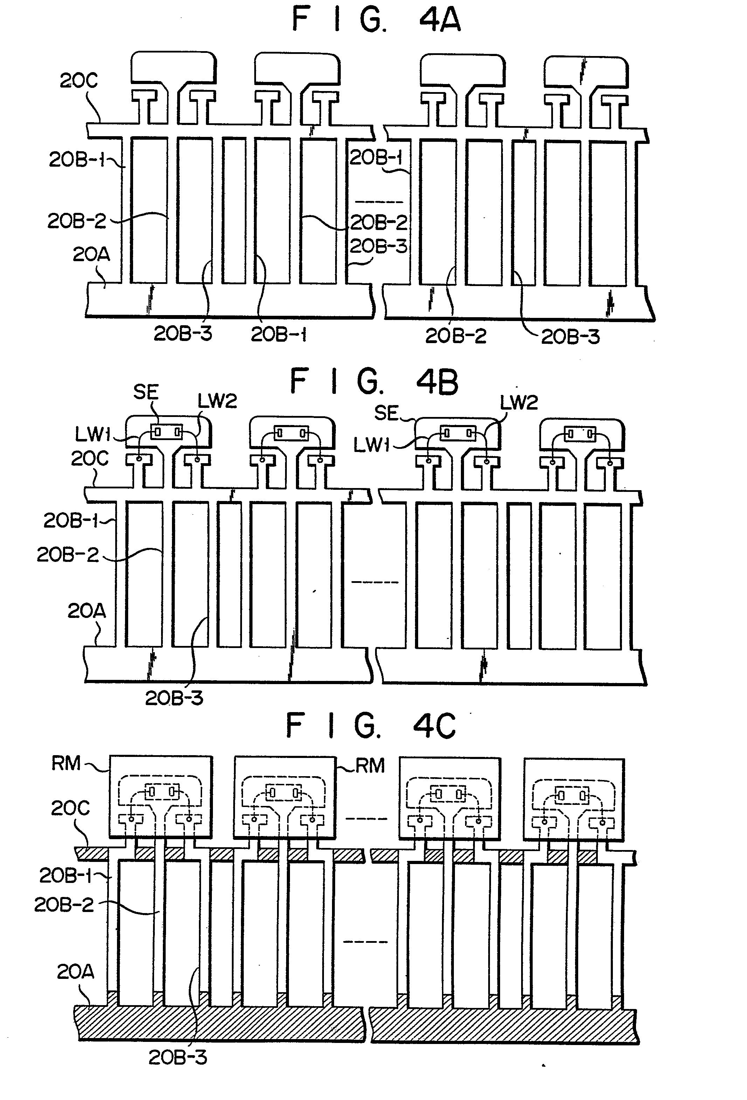

Figs. 4A to 4C illustrate manufacturing steps to manufacture semiconductor devices of the resin sealing types using lead frames according to one embodiment of the present invention.

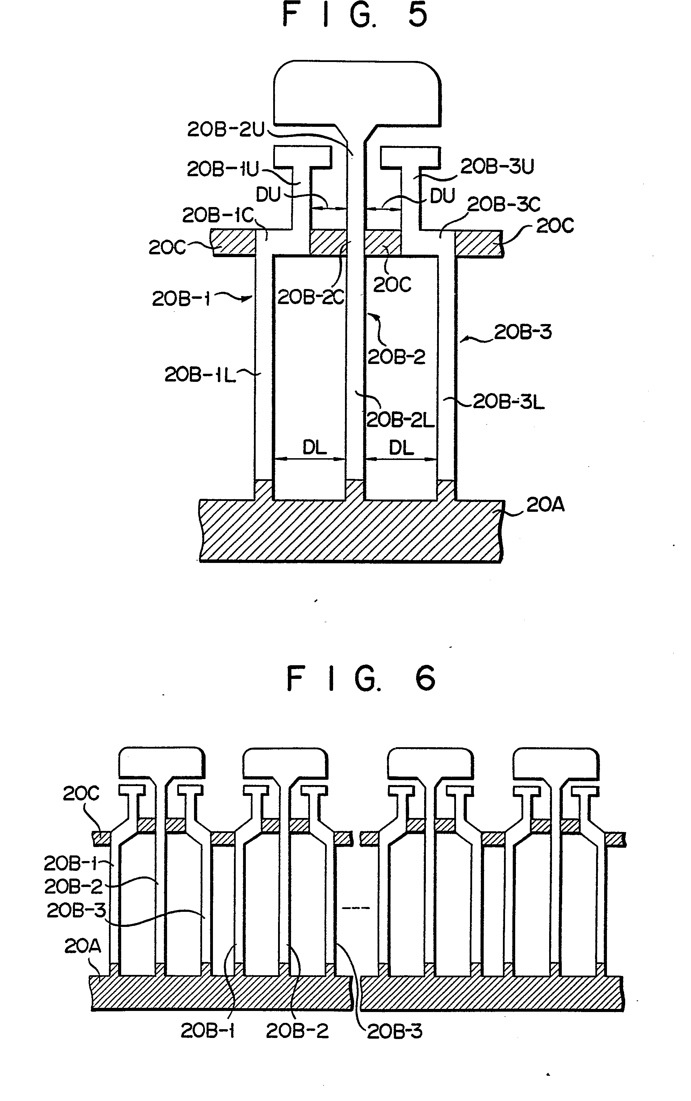

First, predetermined portions of a sheet of thin metal plate are selectively removed due to a punching method or etching method, thereby forming a lead frame as shown in Fig. 4A. This lead frame has a series of lead frame units. As shown in Fig. 5, this lead frame unit comprises a base plate 20A; three lead bars 20B-1 to 20B-3; and a tie bar 20C for coupling these lead bars. The lead bars 20B-1 to 20B-3 respectively have lower portions 20B-1L to 20B-3L which extend upwardly from the base plate 20A in parallel with one another and upper portions 20B-1U to 20B-3U which extend from the tie bar 20C upwardly in parallel with one another. Further, the lead bars 20B-1 to 20B-3 respectively have coupling portions 20B-1C to 20B-3C for respectively coupling the lower portions 20B-1L to 20B-3L to the upper portions 20B-1U to 20B-3U. In the embodiment, the head of the central upper portion 20B-2U is formed large so as to mount a semiconductor element or elements. The heads of the other upper portions 20B-1U and 20B-3U are formed slightly large so as to easily obtain the electrical connection with the semiconductor element mounted on the head of the upper portion 20B-2U.

As will be obviously understood from Fig. 5, a distance DU between the upper portion 20B-1U or 20B-3U and the upper portion 20B-2U is set to a value which is different from a distance DL between the lower portion 20B-1L or 20B-3L and the lower portion 20B-2L. Namely, the distance DU between the upper portions 20B-1U to 20B-3U is set to an appropriate value in conformity with the dimensions of a resin mold for sealing the semiconductor element mounted on the upper portion 20B-2U and with the specifications of a bonding apparatus. On the other hand, the distance DL between the lower portions 20B-1L to 20B-3L is set in compliance with the specifications of the automatic inserting apparatus. In this lead frame, the coupling portions 20B-1C to 20B-3C of the lead bars 20B-1 to 20B-3 are mutually coupled by the tie bar 20C.

As shown in Fig. 4B, a semiconductor element SE is fixedly mounted on the head of the central lead bar 20B-2 of each lead frame unit of the lead frame obtained in this way. Next, electrode pads of the semiconductor element SE are respectively bonding-coupled to the heads of the lead bars 20B-1 and 20B-3 through lead wires LW1 and LW2. Thereafter, as shown in Fig. 4C, a resin mold RM is formed so as to enclose the heads of the lead bars 20B-1 to 20B-3, semiconductor element SE, and lead wires LW1 and LW2. Next, the base plate 20A (hatched portion) is separated from the lead bars 20B-1 to 20B-3, and the tie bar 20C (hatched portions) is removed. Thus, the semiconductor device in which the distance between the leads was set to a desired value is obtained.

For instance, the semiconductor devices derived in this way are stuck as they are onto the pasteboard in accordance with the radial lead taping method, which has been explained in conjunction with Fig. 3.

As described above, in the present invention, the lead frame is derived by selectively removing the predetermined portions of a sheet of a thin metal plate by a punching method or etching method, and there is no need to perform the lead bending work. Therefore, the error in distance between the lead bars of this lead frame is influenced by only the manufacturing error of the lead frame and is ordinarily ± 0.05 mm. In this way, since the mutual distance between the lead bars can be set very accurately, the automatic inserting apparatus can insert the lead bars into the insertion holes in the printed circuit board with a probability of almost 100%. Thus, there is hardly a case where the availability factor of the automatic inserting apparatus decreases due to the erroneous insertion.

Further, since the lead frame formed in accordance with the invention can be used as it is without being subjected to the lead bending in manufacturing the semiconductor device, the manufacturing steps can be simplified. In addition, the occurrence of inferior goods, which have been conventionally caused in this lead bending, is eliminated, so that the yield is also improved.

Fig. 6 shows a lead frame according to another embodiment of the invention. This lead frame is constituted similarly to that shown in Fig. 4A, except that the coupling portions of the respective lead bars 20B-1 and 20B-3 are slanted. In this lead frame, the upper ends of the coupling portions of the lead bars 20B-1 and 20B-3 are together coupled to the coupling portion of the lead bar 20B-2 through the tie bar 20C. On one hand, the lower end of the coupling portion of the lead bar 20B-3 of a certain lead frame unit is coupled to the lower end of the coupling portion of the lead bar 20B-1 of the lead frame unit at the next stage through the tie bar 20C. In this way, even in the lead frame having the lead bars with the coupling portions slanted, the distance between the lead bars can be set with a high degree of accuracy.

Although the present invention has been described above with respect to the embodiments, the invention is not limited to only these embodiments. For instance, although each lead frame unit is formed to have three lead bars in the foregoing embodiments, it may be formed to have two or four or more lead bars. On the other hand, although the resin mold RM is formed for every lead frame unit, a plurality of lead frame units may be combined by one resin mold.

Claims:

1.  A lead frame comprising: a base plate (20A); a plurality of lead bars (20B-1 to 20B-3) extending from said base plate (20A) substantially in parallel with one another; and a tie bar (20C) for interconnecting said lead bars (20B-1 to 20B-3), and each of said lead bars (20B-1 to 20B-3) being formed of an upper portion (20B-1U to 20B-3U), a lower portion (20B-1L to 20B-3L) and a coupling portion (20B-1C to 20B-3C) for coupling said upper and lower portions (20B-1U to 20B-3U; 20B-1L to 20B-3L), characterized in that a distance between said upper portions (20B-1U to 20B-3U) is set to be different from a distance between said lower portions (20B-1L to 20B-3L) by said coupling portions (20B-1C to 20B-3C).

2.  A lead frame according to claim 1, characterized in that said plurality of lead bars are divided into a plurality of lead bar groups each including first to third lead bars (20B-1 to 20B-3), and the distance between the upper portions (20B-1U to 20B-3U) of said first to third lead bars (20B-1 to 20B-3) is set to be narrower than the distance between said lower portions (20B-1L to 20B-3L) by said coupling portions (20B-1C to 20B-3C).

3.  A lead frame according to claim 2, characterized in that the coupling portions (20B-1C to 20B-3C) of said lead bars (20B-1 to 20B-3) and said tie bar (20C) are arranged substantially on a straight line.

4.  A lead frame according to claim 2, characterized in that the coupling portions of said first and second lead bars (20B-1, 20B-3) are formed at a preset angle with respect to said third lead bar (20B-2), and the upper ends of the coupling portions of said first and second lead bars (20B-1, 20B-3) are coupled to the coupling portion of said third lead bar (20B-2).

5.  A method of manufacturing a resin sealed type semiconductor device comprising the steps of: preparing a lead frame including a plurality of distinguishable units which are joined with a base plate, said unit comprising substantially parallel lead bars which each have a lower portion extending from the base plate, a coupling portion and an upper portion in series, a distance between said upper portions being set to be different from a distance between said lower portions, and a tie bar for interconnecting the coupling portions of said lead bars; fixedly mounting a semiconductor element onto the upper portion of one of said lead bars in each unit; electrically connecting said semiconductor element and the upper portion of a different one of said lead bars in each unit by a lead wire; encapsulating the upper portion of the lead bar onto which said semiconductor element was mounted and said lead wire in a resin; and removing said base plate and tie bar to separate said unit having leads bent by the presence of the coupling portions.

0143441

F I G. 1

F I G. 2

F I G. 3

F I G. 4A

20C
20B-1
20B-2
20A
20B-3  20B-1

20B-1
20B-2
20B-3
20B-2  20B-3

F I G. 4B

SE  LW2
LW1
20C
20B-1
20B-2
20A
20B-3

SE  LW2
LW1

F I G. 4C

RM
20C
20B-1
20B-2
20A
20B-3

RM

0143441

F I G. 5

F I G. 6